# EUROPEAN PATENT APPLICATION

(11) **EP 4 835 171 A1**
(43) Date of publication of application: **04.11.2026**
(21) Application number: 26174656.4
(22) Date of filing: 27.04.2026
(51) Int. Cl.: C25F 3/12, C25F 7/00, H10P 50/61

(54) **SEMICONDUCTOR PHOTOELECTROCHEMICAL ETCHING APPARATUS**

(30) Priority: 02.05.2025 US 202519197295
(71) Applicant: The Boeing Company, Arlington, VA 22202 (US)
(72) Inventor: LIPTON, Jason Samuel, Arlington, 22202 (US); GRAETZ, Jason Allan, Arlington, 22202 (US); YURASH, Brett Alexander, Arlington, 22202 (US); VAJO, John James, Arlington, 22202 (US); MOTT, Russell Patrick, Arlington, 22202 (US); SORENSEN, Adam Eric, Arlington, 22202 (US); CUI, Shanying, Arlington, 22202 (US)
(74) Representative: Bugnion S.p.A. - US1

(57) **Abstract**

Semiconductor photoelectrochemical etching apparatuses and method of photoelectrochemical etching are presented. A semiconductor photoelectrochemical etching apparatus comprises a photoelectrochemical flow cell; a circulating electrolyte solution propelled through the photoelectrochemical flow cell by a circulating electrolyte pump; a UV light source directed towards the photoelectrochemical flow cell, wherein an optical path length between the UV light and the photoelectrochemical flow cell is set to collect high power light from the UV light; and a turbulence generator configured to generate a turbulent flow in the circulating electrolyte solution.

## Description

### BACKGROUND INFORMATION

### 1. Field:

The present disclosure relates generally to semiconductors, and more specifically to a method and system for efficient photoelectrochemical etching of a semiconductor substrate using a photoelectrochemical etching apparatus.

### 2. Background:

Photonic circuits, also known as integrated optical circuits, manipulate photons to perform various functions similar to how electronic circuits manipulate electrons. Photonic circuits are used in applications such as telecommunications, sensing, signal processing, and quantum computing. Photonic circuits include components like waveguides, modulators, detectors, and light sources integrated on a chip.

Silicon Carbide on Insulator (SiCOI)technology is widely used in the fabrication of photonic circuits. SiCOI is a semiconductor technology that integrates a thin layer of silicon carbide (SiC) on an insulating substrate, typically silicon dioxide (SiO2). SiC has wide bandgap characteristics which allow operation at higher frequencies and powers, reducing signal loss and increasing efficiency. Also, SiC dissipates heat effectively which is crucial for high-power photonic applications. Furthermore, SiC is resistant to harsh environmental conditions, making it suitable for durable photonic devices. These properties make SiC ideal in photonic circuits.

A SiCOI structure includes multiple layers. A substrate layer, such as Si, provides a mechanical support base.

An insulator layer, such as silicon dioxide (SiO2), is formed on top of the substrate layer. The insulator layer electrically isolates a top layer, such as a thin layer of SiC, from the substrate layer, minimizing parasitic capacitance and leakage current. Photonic devices are fabricated on the top layer. Production of SiC-on-insulator (SiCOI) structures involves multiple steps including growth, bonding and substrate removal.

In photonic circuits, maintaining a uniform cross-sectional dimension of a wafer is crucial for consistent light propagation. Thickness variations in SiC can change the optical path lengths, causing phase errors and signal degradation. Non-uniform SiC layers can lead to refractive index variations, impacting the performance of devices like modulators, resonators, and filters. The variation in thickness is measured as the Total Thickness Variation (TTV) which is the difference between the maximum and minimum thicknesses observed in a material layer across a wafer. A low TTV indicates that the SiC layer is planar and uniform in thickness. A high TTV indicates there are significant thickness variations, which can lead to poor device performances and issues in subsequent processing steps.

There are two conventional methods for substrate removal. A first "smart-cut" technique uses ion implantation to create an amorphous layer at a defined depth such as < 1 µm. This "smart-cut" method can create damaged regions, which can lead to unstable spin defects with poor quantum coherence as well as devices with high propagation loss in photonic waveguides.

A second flip and mechanical grind technique can be used for substrate removal. Flip and mechanical grind can create greater than 3um thickness variation across the wafer, which is not tolerable for photonic components. While additional process steps such as polishing and ion etching are typically included, those techniques will not reduce the thickness variation introduced by grinding.

A process known as photoelectrochemical (PEC) etching can be used to etch SiC material to a desired etch depth. However, uniformity of photoelectrochemical etching can be less than desired with current methods.

Therefore, it would be desirable to have a method and apparatus that takes into account at least some of the issues discussed above, as well as other possible issues.

### SUMMARY

An embodiment of the present disclosure provides a semiconductor photoelectrochemical etching apparatus.

The semiconductor photoelectrochemical etching apparatus comprises a photoelectrochemical flow cell, a circulating electrolyte solution propelled through the photoelectrochemical flow cell by a circulating electrolyte pump, a UV light source directed towards the photoelectrochemical flow cell, wherein an optical path length between the UV light source and the photoelectrochemical flow cell is set to collect high power light from the UV light source, and a turbulence generator configured to generate a turbulent flow in the circulating electrolyte solution.

In one example, the circulating electrolyte solution comprises at least one of potassium hydroxide, sodium hydroxide, lithium hydroxide, hydrogen fluoride, or a buffer solution.

In one example, the UV light source is a lamp configured to emit a narrow band or combination of narrow bands of light comprising wavelength lower than 300 nm.

In one example, the optical path length through the photoelectrochemical flow cell is sufficient to collect more than 50 mW/cm2 from the UV light source.

In one example, the UV light source comprises a divergent LED light source, and the optical path length is configured to collect high power light from the divergent LED light source.

In one example, the semiconductor photoelectrochemical etching apparatus further comprises a ground glass diffuser configured to provide light uniformity higher than 80% across a surface of a semiconductor substrate.

In one example, the UV light source is a LED light source.

In one example, the UV light source is an excimer laser or an excimer lamp.

In one example, the UV light source comprises at least one LED light source without lenses.

In one example, the UV light source comprises a Mercury arc lamp or a Mercury-Xenon arc lamp.

In one example, the photoelectrochemical flow cell comprises nozzles configured to receive the circulating electrolyte solution from the circulating electrolyte pump and to generate a flow pattern that results in a turbulent flow across a surface of a semiconductor substrate in the semiconductor photoelectrochemical etching apparatus.

In one example, the turbulence generator comprises a piezoelectric positioned for vibration to induce turbulent flow at a surface of a semiconductor substrate. In one example, the semiconductor photoelectrochemical etching apparatus further comprises at least one of a number of process monitoring ports (122) or a number of process monitoring windows (124).

Another embodiment of the present disclosure provides a method of photoelectrochemical etching a semiconductor substrate. A semiconductor substrate is placed in an etching chamber of a semiconductor photoelectrochemical etching apparatus having an optical path length set to collect high power light from a UV light source. The semiconductor substrate is submerged in a circulating electrolyte solution within the etching chamber. A turbulent flow of the circulating electrolyte solution is generated across a surface of the semiconductor substrate. The semiconductor substrate is illuminated with UV light from the UV light source having a selected wavelength to irradiate the surface of the semiconductor substrate to etch the semiconductor substrate with a total thickness variation within tolerance.

In one example, generating the turbulent flow of the circulating electrolyte solution comprises directing the circulating electrolyte solution in the etching chamber using electrolyte nozzles connected to an electrolyte inlet.

In one example, generating the turbulent flow of the circulating electrolyte solution comprises applying a sonicator to the circulating electrolyte solution.

In one example, generating the turbulent flow of the circulating electrolyte solution comprises applying a sonicator to a photoelectrochemical flow cell forming the etching chamber.

In one example, generating the turbulent flow of the circulating electrolyte solution comprises stirring the circulating electrolyte solution in the etching chamber. Yet another embodiment of the present disclosure provides a method of photoelectrochemical etching a semiconductor substrate. A semiconductor substrate is placed in an etching chamber of a semiconductor photoelectrochemical etching apparatus having an optical path length set to collect high power light from an LED light source. The semiconductor substrate is submerged in a circulating electrolyte solution within the etching chamber. A turbulent flow of the circulating electrolyte solution is generated across a surface of the semiconductor substrate. A bias voltage is applied between the semiconductor substrate and the circulating electrolyte solution. The semiconductor substrate is illuminated with UV light from the LED light source having a selected wavelength below 300 nm to irradiate the surface of the semiconductor substrate with light uniformity >80% of the surface of the semiconductor substrate to etch the semiconductor substrate with a total thickness variation within tolerance.

In one example, generating the turbulent flow of the circulating electrolyte solution comprises directing the circulating electrolyte solution in the etching chamber using electrolyte nozzles connected to an electrolyte inlet.

The features and functions can be achieved independently in various embodiments of the present disclosure or may be combined in yet other embodiments in which further details can be seen with reference to the following description and drawings.

### BRIEF DESCRIPTION OF THE DRAWINGS

The novel features believed characteristic of the illustrative embodiments are set forth in the appended claims. The illustrative embodiments, however, as well as a preferred mode of use, further objectives and features thereof, will best be understood by reference to the following detailed description of an illustrative embodiment of the present disclosure when read in conjunction with the accompanying drawings, wherein:
**Figure 1** is an illustration of a block diagram of a manufacturing environment in accordance with an illustrative embodiment;
**Figure 2** is an illustration of an exploded view of a semiconductor photoelectrochemical etching apparatus in accordance with an illustrative embodiment;
**Figure 3** is an illustration of a front view of a photoelectrochemical flow cell in accordance with an illustrative embodiment;
**Figure 4** is an illustration of a front view of a photoelectrochemical flow cell in accordance with an illustrative embodiment;
**Figure 5** is an illustration of a front view of a photoelectrochemical flow cell in accordance with an illustrative embodiment;
**Figure 6** is a flowchart of a method of photoelectrochemical etching a semiconductor substrate in accordance with an illustrative embodiment; and
**Figure 7** is a flowchart of a method of photoelectrochemical etching a semiconductor substrate in accordance with an illustrative embodiment.

### DETAILED DESCRIPTION

The illustrative examples recognize and take into account several considerations. The illustrative examples recognize and take into account that wide-gap semiconductors, including aluminum nitride (AlN), gallium nitride (GaN), and silicon carbide (SiC) are used in commercial devices such as blue light-emitting diodes, micro-electromechanical systems(MEMS), and high-frequency and high-power electronics. The illustrative examples recognize and take into account that these materials do not grow defect-free single crystals on common, low-cost substrates such as silicon and silicon oxide due to lattice mismatches. The illustrative examples recognize and take into account that the defects has limited the use of these wide-gap semiconductors as thin films for integrated photonic devices (both linear and nonlinear) and low-loss electro-optical devices. The illustrative examples recognize and take into account that among processes for etching SiC, AlN, and GaN, photoelectrochemical (PEC) etching is selective depending on the material doping-type, and PEC etching has been used to fabricate undercut photonic structures by etching in-plane or laterally from recesses etched into the Si-face of SiC.

The illustrative examples recognize and take into account that photoelectrochemical (PEC) etching can be used to etch SiC material to a desired etch depth, for example, 1 micrometer, 5 micrometers, or 7 micrometers. The illustrative examples recognize and take into account that in PEC etching a SiC substrate is placed in an etching chamber equipped with an ultra-violet (UV) light source. The illustrative examples recognize and take into account that the SiC substrate is submerged in an electrolyte solution within the etching chamber, and a bias voltage is applied between the semiconductor substrate and the circulating electrolyte solution. The illustrative examples recognize and take into account that the semiconductor substrate is then illuminated with UV light emitted by the light source. The illustrative examples recognize and take into account that as the UV light irradiates the semiconductor substrate's surface, an oxidation reaction forms oxide on the surface. The illustrative examples recognize and take into account that the oxide is subsequently dissolved by the circulating electrolyte solution. The illustrative examples recognize and take into account that the semiconductor substrate is etched until a desired etch depth is achieved. The illustrative examples recognize and take into account that the etch rate of the semiconductor substrate and the etching surface roughness are controlled by varying the intensity of the UV light and by adjusting the bias voltage.

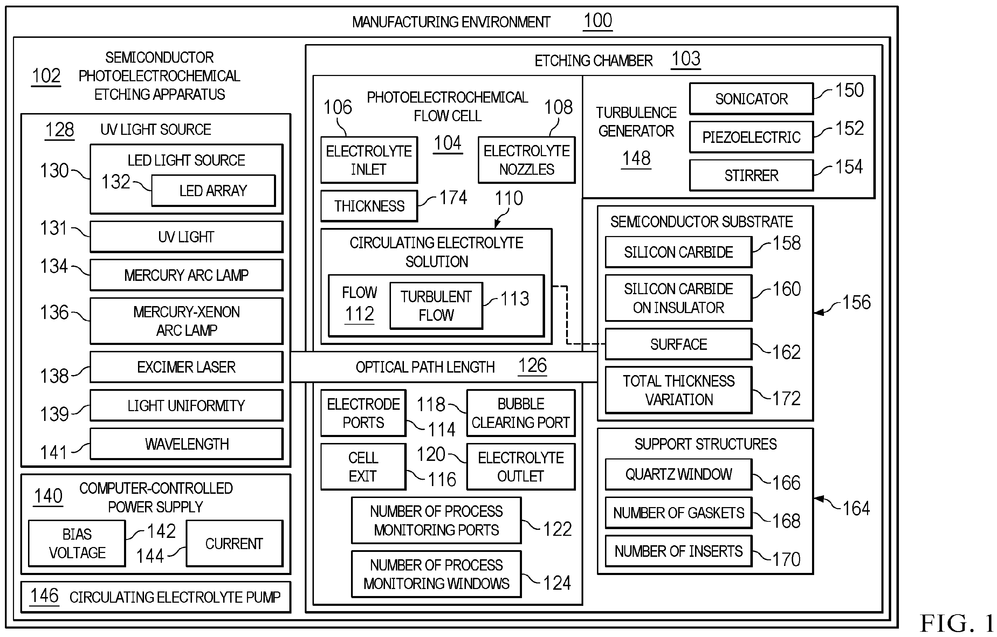

The illustrative examples recognize and take into account that conventional PEC etching can result in less than uniform etching. The illustrative examples provide a PEC etching apparatus design for doing wafer-scale SiC PEC etching to accommodate LED arrays with uniform, smooth, selective etching. The illustrative examples provide designs that control aspects important for yielding low-TTV SiC-on-insulator, including light uniformity, electrolyte flow, and photoelectrochemical cell design. Turning now to **Figure 1****,** an illustration of a block diagram of a manufacturing environment 100 is depicted in accordance with an illustrative embodiment. Semiconductor photoelectrochemical etching apparatus 102 can be used for etching semiconductor substrate 156. Etching semiconductor substrate **156** can be used as part of a process to prepare SiC on insulator with low total thickness variation **172** and smooth surfaces. One example of a process to prepare SiC on insulator involves SiC epitaxial growth, flipping and bonding the wafer, grinding / polishing, and PEC etching of the SiC sacrificial layer. The illustrative examples provide characteristics for the PEC etching step, to produce a smooth surface with low total thickness variation **172.** Wavelength **141** is important for effective PEC etching.

In some illustrative examples, wavelength **141** is provided using LED light source **130.** Additional parameters for PEC etching comprises optical path length **126,** light uniformity **139,** and characteristics of flow **112** of circulating electrolyte solution **110.**

Semiconductor photoelectrochemical etching apparatus **102** comprises photoelectrochemical flow cell **104,** circulating electrolyte solution **110** propelled through photoelectrochemical flow cell **104** by circulating electrolyte pump **146;** UV light source **128** directed towards photoelectrochemical flow cell **104,** wherein optical path length **126** between UV light source **128** and photoelectrochemical flow cell **104** is set to collect high power light from UV light source **128,** and turbulence generator **148** configured to generate turbulent flow **113** in circulating electrolyte solution **110.** UV light source **128** provides UV light **131.**

In some illustrative examples, semiconductor photoelectrochemical etching apparatus **102** further comprises computer-controlled power supply **140.** In some illustrative examples, computer-controlled power supply **140** applies a bias where bias voltage **142** is constant or variable, with either constant or oscillating current **144.**

In some illustrative examples, semiconductor photoelectrochemical etching apparatus **102** further comprises an additional computer-controlled power supply. In some illustrative examples, the additional computer-controlled power supply can be attached to photoelectrochemical flow cell **104** to bias differently doped layers of the semiconductor stack in semiconductor substrate **156** with respect to each other.

In some illustrative examples, circulating electrolyte solution **110** comprises at least one of potassium hydroxide, sodium hydroxide, lithium hydroxide, hydrogen fluoride, or a buffer solution. In some illustrative examples, UV light source **128** is selected for wavelength **141.** In some illustrative examples, UV light source **128** is a lamp which emits a narrow band or combination of narrow bands of light comprising wavelength <300 nm.

In some illustrative examples, optical path length **126** through photoelectrochemical flow cell **104** is sufficient to collect >50 mW/cm² from UV light source **128.** In some illustrative examples, optical path length **126** through photoelectrochemical flow cell **104** is sufficient to collect >100 mW/cm² from UV light source **128.** In some illustrative examples, optical path length **126** through photoelectrochemical flow cell **104** is sufficient to collect >150 mW/cm² from UV light source **128.** In some illustrative examples, optical path length **126** through photoelectrochemical flow cell **104** is sufficient to collect >200 mW/cm² from UV light source **128.** In some illustrative examples, UV light source **128** is selected from at least one of LED light source **130,** mercury arc lamp **134,** mercury-xenon arc lamp **136,** excimer laser **138,** or an excimer lamp. In some illustrative examples, LED light source **130** takes the form of LED array **132.**

The illustrative examples recognize that the uniform distribution of light intensity is important to high-quality low-TTV SiCOI fabrication. In some illustrative examples, when using mercury arc lamp **134,** focusing is utilized to have UV-C light intensity high enough for smooth SiCOI etching.

For LED light source **130** without focusing lenses, the LED source may be referred to as a divergent LED light source. UV-C LED array **132** that is not focused, emits light from each chip that is highly divergent, with a throwing angle of 120°. Thus, at the distances chosen for PEC etching, the incident light intensity is significantly more uniform over surface **162** of semiconductor substrate **156** than mercury arc lamp **134.** Greater light uniformity **139** results in a lower TTV for the LED etch. as compared to the mercury lamp etch, despite >2X larger area. The light intensity pattern does not appear to be the limiting factor for TTV reduction in this when using an unfocused LED array.

In some illustrative examples, photoelectrochemical flow cell **104** comprises optical path length **126** configured to collect high power light from a divergent LED light source, LED light source **130.** In some illustrative examples, UV light source **128** is LED light source **130.**

In some illustrative examples, UV light source **128** comprises at least one LED light source **130** without lenses.

In some illustrative examples, UV light source **128** comprises one of mercury arc lamp **134** or mercury-xenon arc lamp **136.** In some illustrative examples, UV light source **128** is one of excimer laser **138** or an excimer lamp. In some illustrative examples, semiconductor photoelectrochemical etching apparatus **102** further comprising a ground glass diffuser configured to provide light uniformity 139 >80% across surface 162 of semiconductor substrate 156.

In some illustrative examples, parameters of circulating electrolyte solution 110 are controlled for improved etching. In some illustrative examples, the temperature of circulating electrolyte solution 110 is within the range of 5 Celsius and 50 Celsius. In some illustrative examples, circulating electrolyte solution 110 is an aqueous solution. In some illustrative examples, the concentration of circulating electrolyte solution 110 is in the range of 0.01 wt% - 15 wt%.

The flow field of circulating electrolyte solution 110 in photoelectrochemical flow cell 104 is a controlled parameter of the illustrative examples to achieve smooth etching over surface 162 of semiconductor substrate 156. Turbulent flow 113 can prevent a barrier layer from forming at surface 162 of semiconductor substrate 156. A barrier layer can cause a local depletion of electrolyte concentration and a buildup of reaction products, resulting in a rough etch surface.

In some illustrative examples, by maintaining turbulent flow 113 over the entirety of surface 162 of semiconductor substrate 156, the barrier layer can be prevented. To generate turbulent flow 113 using electrolyte nozzles 108, a relatively high flow rate is used. In some illustrative examples, to generate turbulent flow 113 using electrolyte nozzles 108 greater than two hundred standard cubic centimeter per minute (sccm) of flow rate is used. In some illustrative examples, electrolyte inlet 106 and electrolyte nozzles **108** are oriented such that eddies or low flow velocity regions do not appear. If the flow inlet is positioned in such a way as to allow for local dead zones, rough regions can appear in the etched semiconductor substrate **156** as compared to a fully turbulent flow field.

Turbulent flow **113** is helpful to success of PEC etching with no haze. In some illustrative examples, turbulent flow **113** can be achieved by applying sonication. In some illustrative examples, sonication can be applied during etching by applying sonication to semiconductor substrate **156.** In some illustrative examples, application of sonication to semiconductor substrate **156** can be referred to as sonication of wafer by application of sonic waves to SiC wafer.

In some illustrative examples, sonication can be applied during etching by applying sonicator **150** to photoelectrochemical flow cell **104.** Sonicator **150** can be applied to a body of photoelectrochemical flow cell **104** to transfer sonic waves to the body of photoelectrochemical flow cell **104.**

In some illustrative examples, sonication can be applied during etching by applying sonicator **150** to circulating electrolyte solution **110.** In these illustrative examples, sonication of circulating electrolyte solution **110** can be accomplished by providing an additional port through photoelectrochemical flow cell **104.** In these illustrative examples, sonicator **150** can take the form of a tip sonicator.

In some illustrative examples, turbulence generator **148** comprises nozzles in photoelectrochemical flow cell **104** receiving circulating electrolyte solution **110** from circulating electrolyte pump to generate flow pattern that results in a turbulent flow **113** across surface **162** of semiconductor substrate **156** in the semiconductor photoelectrochemical etching apparatus.

In some illustrative examples, turbulence generator **148** comprises piezoelectric **152** positioned for vibration to induce turbulent flow **113** at surface **162** of semiconductor substrate **156.** In some illustrative examples, turbulence generator **148** comprises stirrer **154** configured to induce turbulent flow **113** at surface **162** of semiconductor substrate **156.**

Photoelectrochemical flow cell **104** comprises electrolyte inlet **106** which delivers circulating electrolyte solution **110** to photoelectrochemical flow cell **104** from circulating electrolyte pump **146.** In some illustrative examples, electrolyte nozzles **108** are used to direct circulating electrolyte solution **110** into photoelectrochemical flow cell **104.** In some illustrative examples, electrolyte nozzles **108** are used to generate turbulent flow **113.** Photoelectrochemical flow cell **104** further comprises electrode ports **114** to allow for bias voltage **142** to be applied to a counter electrode in circulating electrolyte solution **110.** Circulating electrolyte solution **110** exits photoelectrochemical flow cell **104** through cell exit **116** and travels through electrolyte outlet **120.** Gases exit photoelectrochemical flow cell **104** through cell exit **116** and bubble clearing port **118.** Electrolyte outlet **120** and bubble clearing port **118** are connected to cell exit **116.** Photoelectrochemical flow cell **104** has thickness **174** configured to collect an appreciable irradiance from UV light source **128.** In some illustrative examples, photoelectrochemical flow cell **104** is sufficiently thin in order to collect >50 mW cm² at 265 nm from LED array **132** when LED array **132** comprises highly divergent unfocused UV-C LED's. Thickness **174** of photoelectrochemical flow cell **104** is configured to permit sufficient flow of circulating electrolyte solution through photoelectrochemical flow cell **104** to exchange waste heat. Photoelectrochemical flow cell **104** has thickness **174** sufficient to allow turbulent flow **113** across surface **162** of semiconductor substrate **156.** In some illustrative examples, thickness **174** is approximately 0.6 cm. In some illustrative examples, optical path length **126** is less than 2.5 cm. In some illustrative examples, thickness **174** is between 0.5 cm to 1 cm and optical path length **126** is less than 3 cm. chamber was determined to be 0.6 cm, resulting in a total distance from LED to SiC surface of 2.3 cm. In these illustrative examples, optical path length **126** was high enough to result in appreciable etching current with low roughness.

In some illustrative examples, the semiconductor photoelectrochemical etching apparatus **102** performs dopant selective PEC etching of SiC using a large 265 nm LED array. In some illustrative examples, semiconductor substrate **156** can be a wafer up to four inches in diameter. In some illustrative examples, LED array **132** is unfocused and larger in diameter than the wafer for light uniformity **139** across surface **162.** Semiconductor photoelectrochemical etching apparatus **102** comprises photoelectrochemical flow cell **104,** along with several support structures **164** to maintain even pressure across semiconductor substrate **156** to mount semiconductor substrate **156** vertically for LED illumination. In these illustrative examples, support structures **164** comprise number of gaskets **168** and number of inserts **170.** Support structures **164** further comprises quartz window **166** for allowing UV light **131** to encounter semiconductor substrate **156.** In some illustrative examples, the overall distance from UV light source **128** to surface **162** of semiconductor substrate **156,** optical path length **126,** is controlled to control UV light **131** received. Maintaining the overall distance at a desired length allows for UV light **131** to blend uniformly while retaining high power.

In some illustrative examples, electrolyte nozzles **108** are arranged for flow from the bottom to the top of photoelectrochemical flow cell **104.** In some illustrative examples, electrolyte nozzles **108** are optional and inlet holes are present instead. In these illustrative examples, the inlet holes are arranged for flow from the bottom to top, with optional inserts to fan the flow, leading to turbulent flow across surface **162** at sufficiently high flow rates. In some illustrative examples, semiconductor photoelectrochemical etching apparatus **102** can also be connected to a second external power supply for biasing individual layers of SiC with respect to each other to improve selectivity.

In some illustrative examples, semiconductor photoelectrochemical etching apparatus **102** further comprises at least one of number of process monitoring ports **122** or number of process monitoring windows **124.** Number of process monitoring ports **122** can be used for counter and reference electrodes as well as for data collection such as for pH monitoring or temperature monitoring. In some illustrative examples, number of process monitoring windows **124** can be used for additional data collection.

In some illustrative examples, semiconductor substrate **156** is a full wafer or piece of wafer. In some illustrative examples, semiconductor substrate **156** comprises one of silicon carbide **158** or silicon carbide on insulator **160.** In some illustrative examples, semiconductor substrate **156** comprises GaN or another semiconductor not mentioned herein. In some illustrative examples, semiconductor substrate **156** comprises multiple layers with doping concentration ranging from 1e15 to 1e19 of either n- or p-type doping or is undoped. In some illustrative examples, semiconductor substrate **156** has contacts for biasing of layers with respect to each other for the purpose of improving etch selectivity. In some illustrative examples, semiconductor substrate **156** comprises a doped silicon carbide **158** or silicon carbide on insulator **160** semiconductor and has an exposed Si-face or C-face surface.

In some illustrative examples, photoelectrochemical etching using semiconductor photoelectrochemical etching apparatus **102** results in smooth (roughness <10 nm) etching of semiconductor substrate **156** to enable use in integrated photonic devices. In some illustrative examples, at least one of optical path length **126,** turbulent flow **113** of circulating electrolyte solution **110,** light uniformity **139,** or wavelength **141** is configured to provide results with roughness <10 nm from etching semiconductor substrate **156.**

In some illustrative examples, photoelectrochemical etching comprises placing semiconductor substrate **156** in etching chamber **103** of semiconductor photoelectrochemical etching apparatus **102** having optical path length **126** set to collect high power light from UV light source **128.** In some illustrative examples, photoelectrochemical etching comprises placing semiconductor substrate **156** in etching chamber **103** of semiconductor photoelectrochemical etching apparatus **102** having optical path length **126** set to collect high power light from LED light source **130.**

In some illustrative examples, photoelectrochemical etching further comprises submerging semiconductor substrate **156** in circulating electrolyte solution **110** within etching chamber **103.** In some illustrative examples, photoelectrochemical etching further comprises generating turbulent flow **113** of circulating electrolyte solution **110** across a surface **162** of semiconductor substrate **156.**

In some illustrative examples, photoelectrochemical etching further comprises applying bias voltage **142** between semiconductor substrate **156** and a counter electrode in circulating electrolyte solution **110.** In some illustrative examples, photoelectrochemical etching further comprises illuminating semiconductor substrate **156** with UV light **131** from UV light source **128** having selected wavelength **141** to irradiate surface **162** of semiconductor substrate **156** to etch semiconductor substrate **156** with total thickness variation **172** within tolerance. In some illustrative examples, photoelectrochemical etching further comprises illuminating semiconductor substrate **156** with UV light **131** from LED light source **130** having selected wavelength **141** below 300 nm to irradiate surface **162** of semiconductor substrate **156** with light uniformity **139** >80% of surface **162** of semiconductor substrate **156** to etch semiconductor substrate **156** with total thickness variation **172** within tolerance.

The illustration of manufacturing environment **100 in** **Figure 1** is not meant to imply physical or architectural limitations to the manner in which an illustrative embodiment may be implemented. Other components in addition to or in place of the ones illustrated may be used. Some components may be unnecessary. Also, the blocks are presented to illustrate some functional components. One or more of these blocks may be combined, divided, or combined and divided into different blocks when implemented in an illustrative embodiment. For example, in some illustrative examples, electrolyte nozzles **108** can be optional.

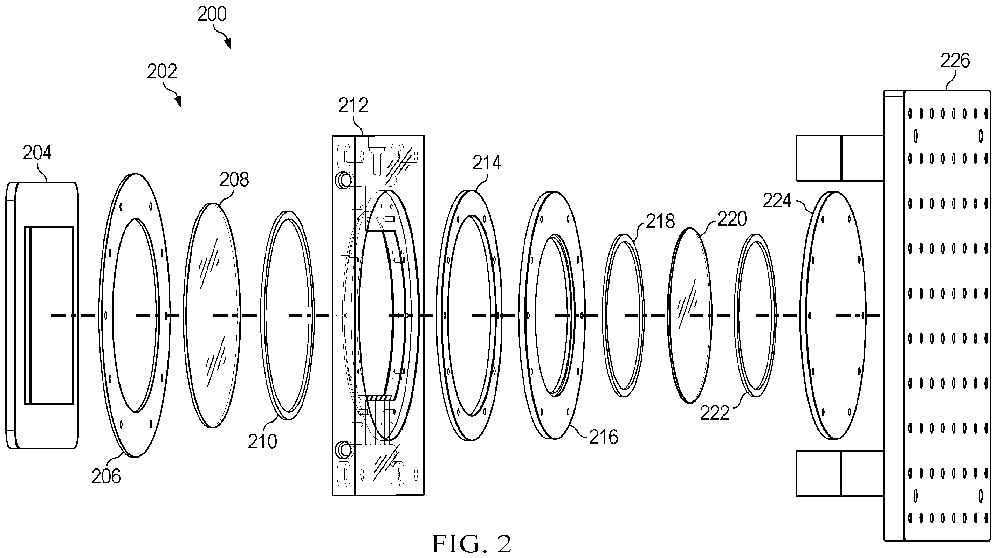

Turning now to **Figure 2****,** an illustration of an exploded view of a semiconductor photoelectrochemical etching apparatus is depicted in accordance with an illustrative embodiment. Semiconductor photoelectrochemical etching apparatus **202** is a physical implementation of semiconductor photoelectrochemical etching apparatus **102 of** **Figure 1****.** Photoelectrochemical flow cell **212** is a physical implementation of photoelectrochemical flow cell **104 of** **Figure 1****.**

In view **200,** semiconductor photoelectrochemical etching apparatus **202** is seen in an exploded form. In this illustrative example, semiconductor photoelectrochemical etching apparatus **202** comprises UV light source in the form of LED light source **204.** LED light source **204** is a UV LED. In this illustrative example, there are not any additional focusing lenses between LED light source **204** and etching chamber **103** of semiconductor photoelectrochemical etching apparatus **102.**

In this illustrative example, a plurality of gaskets, inserts, and rings are present to form etching chamber **103** of semiconductor photoelectrochemical etching apparatus **102.** Window holding ring **206** and UV window gasket **210** are on either side of quartz window **208.** Photoelectrochemical flow cell **212** comprises the active areas for receiving semiconductor substrate **220** and circulating electrolyte solution. Photoelectrochemical flow cell **212** comprises a plurality of features including an electrolyte inlet, an electrolyte outlet, electrode ports, and a cell entrance with electrolyte attachments. Modifying aspects of photoelectrochemical flow cell **212** can modify the etching process of semiconductor substrate **220.** Aspects of photoelectrochemical flow cell **212** include a thickness to modify an optical path length and a flow pattern of the circulating electrolyte solution.

Window insert gasket **214** and variable window insert **216** are between photoelectrochemical flow cell **212** and mounting board **226.** Wafer/ohmic gasket **218** and backing gasket **222** are on opposite sides of semiconductor substrate **220.** In this illustrative example, semiconductor substrate **220** takes the form of a 100 mm wafer. Providing desirable light uniformity and characteristics of photoelectrochemical flow cell **212** allows for etching of larger semiconductor substrates than conventional processes.

Semiconductor photoelectrochemical etching apparatus **202** further comprises locking insert **224** for completing the etching chamber. Mounting board **226** provides mounting for semiconductor photoelectrochemical etching apparatus **202.**

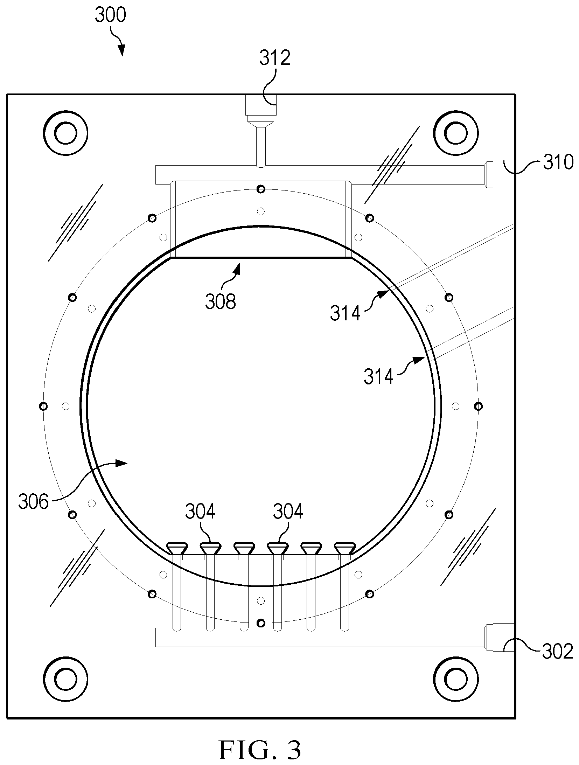

Turning now to **Figure 3****,** an illustration of a front view of a photoelectrochemical flow cell is depicted in accordance with an illustrative embodiment. Photoelectrochemical flow cell **300** can be a physical implementation of photoelectrochemical flow cell **104 of** **Figure 1****.** Photoelectrochemical flow cell **300** can be a physical implementation of photoelectrochemical flow cell **104 of** **Figure 1****.**

Photoelectrochemical flow cell **300** is an illustrative example of a photoelectrochemical flow cell with a turbulent flow of circulating electrolyte solution (not depicted) generated through the introduction of circulating electrolyte solution to cavity **306.** Electrolyte inlet **302** receives circulating electrolyte solution from a circulating electrolyte pump (not depicted). Electrolyte inlet **302** is a pathway for circulating electrolyte solution to nozzles **304.** Nozzles **304** direct circulating electrolyte solution in such a way that turbulent flow is accomplished over a surface of a semiconductor substrate (not depicted) in cavity **306.** Nozzles **304** are designed to generate turbulent flow. Nozzles **304** can have any desirable size, shape, and quantity configured to generate the turbulent flow across a surface of the semiconductor substrate in cavity **306.** To exit cavity **306,** circulating electrolyte solution travels through cell exit **308.** Circulating electrolyte solution exits through electrolyte outlet **310.** Bubble clearing port **312** allows for the exit of gases from photoelectrochemical flow cell **300.** Electrode ports **314** in photoelectrochemical flow cell **300** allow for electrodes to be placed in circulating electrolyte solution within cavity **306.**

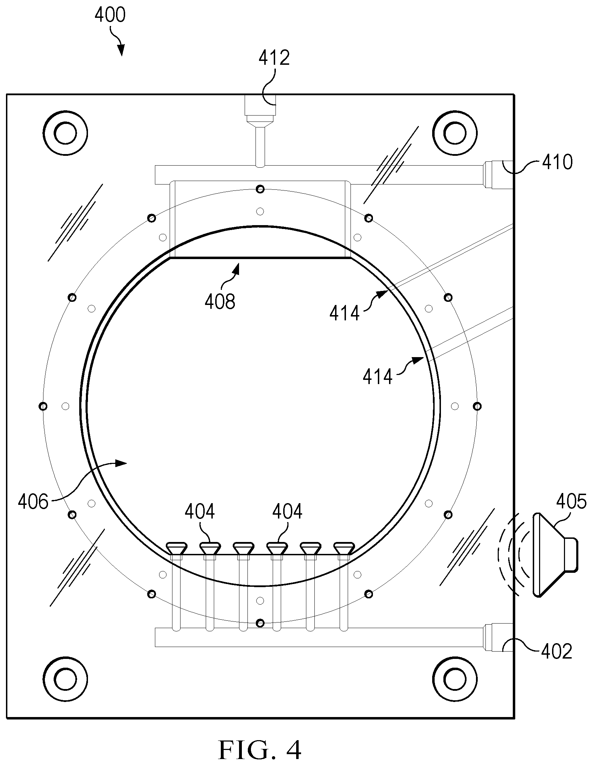

Turning now to **Figure 4****,** an illustration of a front view of a photoelectrochemical flow cell is depicted in accordance with an illustrative embodiment. Photoelectrochemical flow cell **400** can be a physical implementation of photoelectrochemical flow cell **104 of** **Figure 1****.** Photoelectrochemical flow cell **400** can be a physical implementation of photoelectrochemical flow cell **104 of** **Figure 1****.**

Electrolyte inlet **402** receives circulating electrolyte solution from a circulating electrolyte pump (not depicted). Electrolyte inlet **402** is a pathway for circulating electrolyte solution to nozzles **404.** Nozzles **404** direct circulating electrolyte solution into cavity **406.**

Photoelectrochemical flow cell **400** is an illustrative example of a photoelectrochemical flow cell with a turbulent flow of circulating electrolyte solution (not depicted) generated through sonication. In this illustrative example, sonicator **405** is directed to the exterior of photoelectrochemical flow cell **400.**

To exit cavity **406,** circulating electrolyte solution travels through cell exit **408.** Circulating electrolyte solution exits through electrolyte outlet **410.** Bubble clearing port **412** allows for the exit of gases from photoelectrochemical flow cell **400.** Electrode ports **414** in photoelectrochemical flow cell **400** allow for electrodes to be placed in circulating electrolyte solution within cavity **406.**

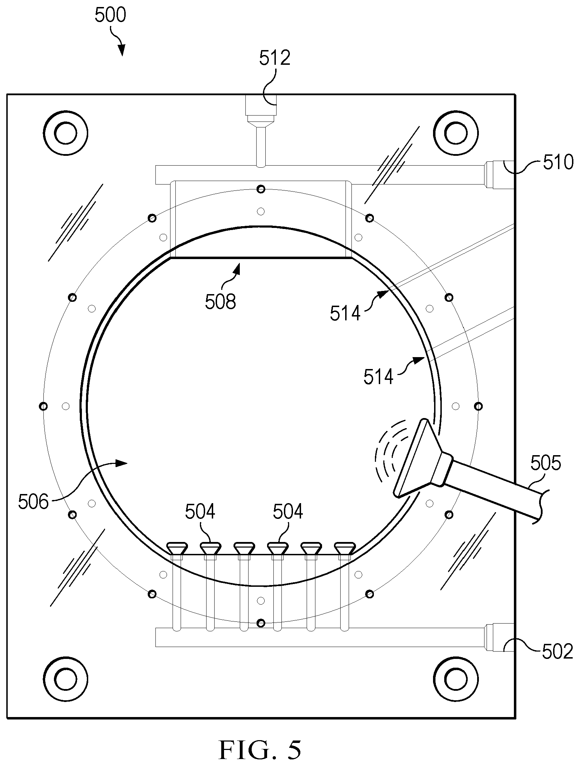

Turning now to **Figure 5****,** an illustration of a front view of a photoelectrochemical flow cell is depicted in accordance with an illustrative embodiment. Photoelectrochemical flow cell **500** can be a physical implementation of photoelectrochemical flow cell **104 of** **Figure 1****.** Photoelectrochemical flow cell **500** can be a physical implementation of photoelectrochemical flow cell **104 of** **Figure 1****.**

Electrolyte inlet **502** receives circulating electrolyte solution from a circulating electrolyte pump (not depicted). Electrolyte inlet **502** is a pathway for circulating electrolyte solution to nozzles **504.** Nozzles **504** direct circulating electrolyte solution into cavity **506.**

Photoelectrochemical flow cell **500** is an illustrative example of a photoelectrochemical flow cell with a turbulent flow of circulating electrolyte solution (not depicted) generated through sonication. In this illustrative example, sonicator **505** is placed into contact with the circulating electrolyte solution within photoelectrochemical flow cell **500.** In this illustrative example, sonicator **505** is a probe extending into photoelectrochemical flow cell **500.**

To exit cavity **506,** circulating electrolyte solution travels through cell exit **508.** Circulating electrolyte solution exits through electrolyte outlet **510.** Bubble clearing port **512** allows for the exit of gases from photoelectrochemical flow cell **500.** Electrode ports **514** in photoelectrochemical flow cell **500** allow for electrodes to be placed in circulating electrolyte solution within cavity **506.**

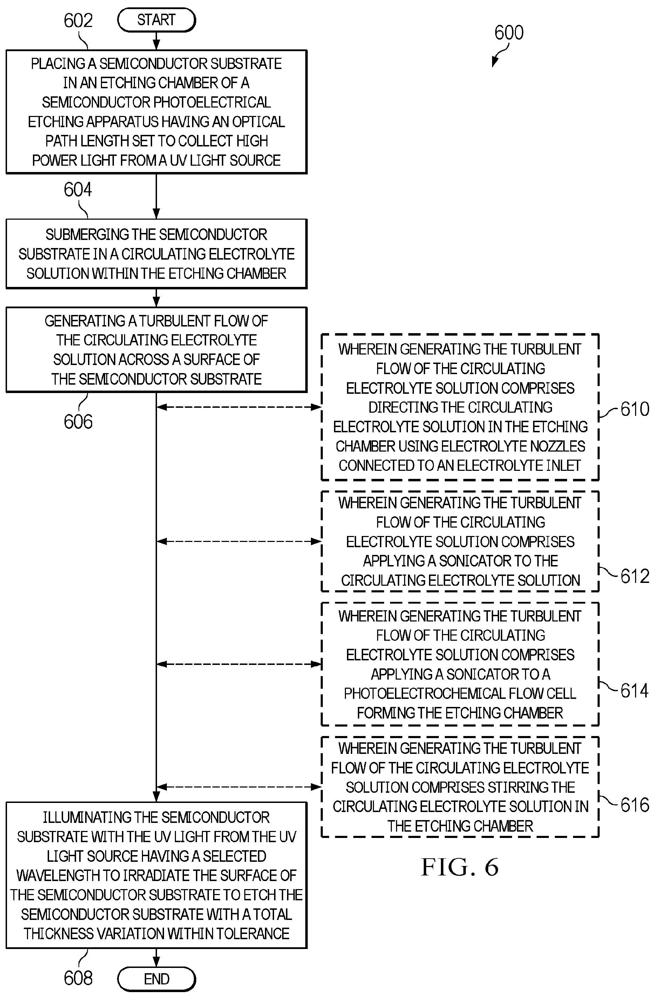

Turning now to **Figure 6****,** a flowchart of a method of photoelectrochemical etching a semiconductor substrate is depicted in accordance with an illustrative embodiment. Method **600** can be performed to etch semiconductor substrate **156** in semiconductor photoelectrochemical etching apparatus **102 of** **Figure 1****.** Method **600** can be performed to etch semiconductor substrate **220** in semiconductor photoelectrochemical etching apparatus **202 of** **Figure 2****.** Method **600** can be performed to etch a semiconductor substrate in photoelectrochemical flow cell **300 of** **Figure 3****.** Method **600** can be performed to etch a semiconductor substrate in photoelectrochemical flow cell **400 of** **Figure 4****.** Method **600** can be performed to etch a semiconductor substrate in photoelectrochemical flow cell **500 of** **Figure 5****.**

Method **600** places a semiconductor substrate in an etching chamber of a semiconductor photoelectrochemical etching apparatus having an optical path length set to collect high power light from a UV light source (operation **602).** Method **600** submerges the semiconductor substrate in a circulating electrolyte solution within the etching chamber (operation **604).**

Method **600** generates a turbulent flow of the circulating electrolyte solution across a surface of the semiconductor substrate (operation **606).** Method **600** illuminates the semiconductor substrate with UV light from the UV light source having a selected wavelength to irradiate the surface of the semiconductor substrate to etch the semiconductor substrate with a total thickness variation within tolerance (operation **608).** Afterwards, method **600** terminates.

In some illustrative examples, generating the turbulent flow of the circulating electrolyte solution comprises directing the circulating electrolyte solution in the etching chamber using electrolyte nozzles connected to an electrolyte inlet (operation **610).** In some illustrative examples, generating the turbulent flow of the circulating electrolyte solution comprises applying a sonicator to the circulating electrolyte solution (operation **612).** In some illustrative examples, generating the turbulent flow of the circulating electrolyte solution comprises applying a sonicator to a photoelectrochemical flow cell forming the etching chamber (operation **614).** In some illustrative examples, generating the turbulent flow of the circulating electrolyte solution comprises stirring the circulating electrolyte solution in the etching chamber (operation **616**).

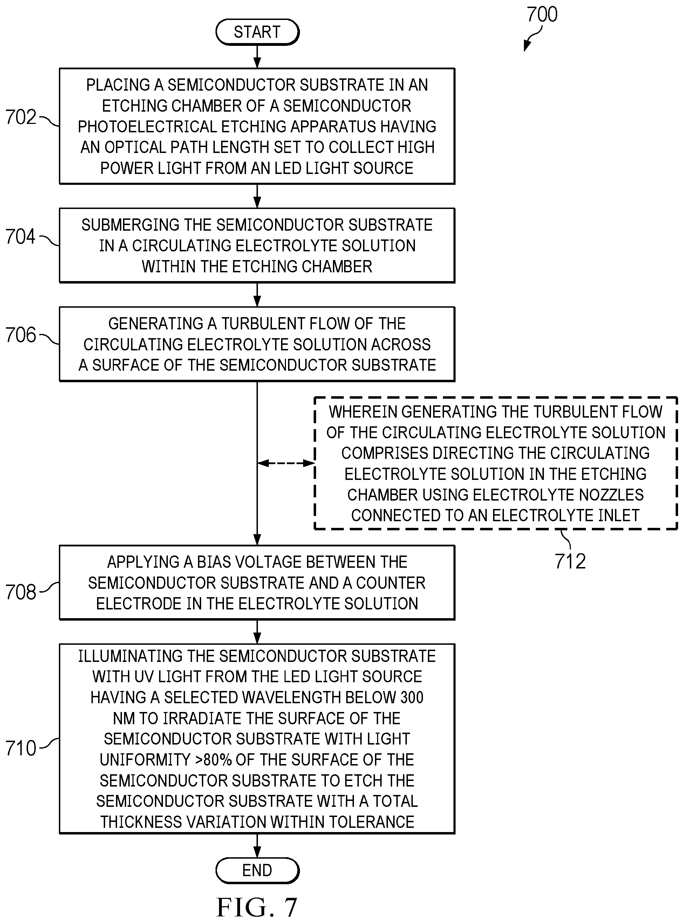

Turning now to **Figure 7****,** a flowchart of a method of photoelectrochemical etching a semiconductor substrate is depicted in accordance with an illustrative embodiment. Method **700** can be performed to etch semiconductor substrate **220** in semiconductor photoelectrochemical etching apparatus **202 of** **Figure 2****.** Method **700** can be performed to etch a semiconductor substrate in photoelectrochemical flow cell **300 of** **Figure 3****.** Method **700** can be performed to etch a semiconductor substrate in photoelectrochemical flow cell **400 of** **Figure 4****.** Method **700** can be performed to etch a semiconductor substrate in photoelectrochemical flow cell **500 of** **Figure 5****.**

Method **700** places a semiconductor substrate in an etching chamber of a semiconductor photoelectrochemical etching apparatus having an optical path length set to collect high power light from an LED light source (operation **702).** Method **700** submerges the semiconductor substrate in a circulating electrolyte solution within the etching chamber (operation **704).** Method **700** generates a turbulent flow of the circulating electrolyte solution across a surface of the semiconductor substrate (operation **706).** Method **700** applies a bias voltage between the semiconductor substrate and a counter electrode in the circulating electrolyte solution (operation **708).** Method **700** illuminates the semiconductor substrate with UV light from the LED light source having a selected wavelength below 300 nm to irradiate the surface of the semiconductor substrate with light uniformity >80% of the surface of the semiconductor substrate to etch the semiconductor substrate with a total thickness variation within tolerance (operation **710).** Afterwards, method **700** terminates. In some illustrative examples, generating the turbulent flow of the circulating electrolyte solution comprises directing the circulating electrolyte solution in the etching chamber using electrolyte nozzles connected to an electrolyte inlet (operation **712).** In these illustrative examples, the electrolyte nozzles are configured to generate the turbulent flow at the surface of the semiconductor substrate. At least one of the size, shape, quantity, or position of the electrolyte nozzles is configured to generate the turbulent flow.

As used herein, the phrase "at least one of," when used with a list of items, means different combinations of one or more of the listed items may be used and only one of each item in the list may be needed. For example, "at least one of item A, item B, or item C" may include, without limitation, item A, item A and item B, or item B. This example also may include item A, item B, and item C or item B and item C. Of course, any combinations of these items may be present. In other examples, "at least one of" may be, for example, without limitation, two of item A; one of item B; and ten of item C; four of item B and seven of item C; or other suitable combinations. The item may be a particular object, thing, or a category. In other words, at least one of means any combination items and number of items may be used from the list but not all of the items in the list are required.

As used herein, "a number of," when used with reference to items means one or more items.

The flowcharts and block diagrams in the different depicted embodiments illustrate the architecture, functionality, and operation of some possible implementations of apparatuses and methods in an illustrative embodiment. In this regard, each block in the flowcharts or block diagrams may represent at least one of a module, a segment, a function, or a portion of an operation or step.

In some alternative implementations of an illustrative embodiment, the function or functions noted in the blocks may occur out of the order noted in the figures. For example, in some cases, two blocks shown in succession may be executed substantially concurrently, or the blocks may sometimes be performed in the reverse order, depending upon the functionality involved. Also, other blocks may be added in addition to the illustrated blocks in a flowchart or block diagram. Some blocks may be optional. For example, operation 610 through operation **616** may be optional. As another example, operation **712** may be optional.

The illustrative examples provide an apparatus for smooth, selective wet etching of the silicon face of SiC that yields a smooth surface and is highly dopant selective. In the illustrative examples, dopant selectivity allows for total thickness variation (TTV) reduction in SiC-on-insulator films for quantum photonics.

The methods of the illustrative examples utilize photoelectrochemical (PEC) processes in which a surface to be etched is irradiated with UV light during electrochemical oxidation. Some of the illustrative examples provide for the use of UV light source with a narrow, photoelectrochemical flow cell, and a quartz window. In the illustrative examples, UV-C LED's can be used here for their areal power and uniformity. In some illustrative examples, other UV-C light sources can also be used.

In some illustrative examples, the LED's have no integrated primary lenses for maximum light uniformity. In some illustrative examples, when using LED's with no lenses, the cell is narrow enough to allow >50 mW cm² of UVC light from divergent LED's to be incident on the SiC surface. In some illustrative examples, when using LED's with no lenses, the flow field is turbulent over the entirety of the SiC surface to reduce or prevent local low-flow regions.

Further examples and combinations thereof include the followings.

Clause 1. A semiconductor photoelectrochemical etching apparatus comprising:
a photoelectrochemical flow cell;
a circulating electrolyte solution propelled through the photoelectrochemical flow cell by a circulating electrolyte pump;
a UV light source directed towards the photoelectrochemical flow cell, wherein an optical path length between the UV light source and the photoelectrochemical flow cell is set to collect high power light from the UV light source; and
a turbulence generator configured to generate a turbulent flow in the circulating electrolyte solution. Clause 2. The semiconductor photoelectrochemical etching apparatus of Clause 1, wherein the circulating electrolyte solution comprises at least one of potassium hydroxide, sodium hydroxide, lithium hydroxide, hydrogen fluoride, or a buffer solution.

Clause 3. The semiconductor photoelectrochemical etching apparatus of Clause 1 or 2, wherein the UV light source is a lamp configured to emit a narrow band or combination of narrow bands of light comprising wavelength <300 nm. Clause 4. The semiconductor photoelectrochemical etching apparatus of any one of the preceding Clauses, wherein the optical path length through the photoelectrochemical flow cell is sufficient to collect >50 mW/cm² from the UV light source.

Clause 5. The semiconductor photoelectrochemical etching apparatus of any one of the preceding Clauses, wherein the UV light source comprises a divergent LED light source, and wherein the optical path length is configured to collect high power light from the divergent LED light source.

Clause 6. The semiconductor photoelectrochemical etching apparatus of any one of the preceding Clauses, further comprising:
a ground glass diffuser configured to provide light uniformity higher than 80% across a surface of a semiconductor substrate.

Clause 7. The semiconductor photoelectrochemical etching apparatus of any one of the preceding Clauses, wherein the UV light source is a LED light source.

Clause 8. The semiconductor photoelectrochemical etching apparatus of any one of Clauses 1 to 6, wherein the UV light source comprises at least one LED light source without lenses.

Clause 9. The semiconductor photoelectrochemical etching apparatus of any one of Clauses 1 to 6, wherein the UV light source comprises a mercury arc lamp or a mercury-xenon arc lamp.

Clause 10. The semiconductor photoelectrochemical etching apparatus of any one of Clauses 1 to 6, wherein the UV light source is one of an excimer laser or an excimer lamp.

Clause 11. The semiconductor photoelectrochemical etching apparatus of any one of the preceding Clauses, wherein the photoelectrochemical flow cell comprises nozzles configured to receive circulating electrolyte solution from the circulating electrolyte pump and to generate a flow pattern that results in a turbulent flow across a surface of a semiconductor substrate in the semiconductor photoelectrochemical etching apparatus.

Clause 12. The semiconductor photoelectrochemical etching apparatus of any one of the preceding Clauses, further comprising a piezoelectric positioned for vibration to induce turbulent flow at a surface of a semiconductor substrate.

Clause 13. The semiconductor photoelectrochemical etching apparatus of any one of the preceding Claims, further comprising:
at least one of a number of process monitoring ports or a number of process monitoring windows.

Clause 14. A method of photoelectrochemical etching a semiconductor substrate, the method comprising the steps of:
placing a semiconductor substrate in an etching chamber of a semiconductor photoelectrochemical etching apparatus having an optical path length set to collect high power light from a UV light source;
submerging the semiconductor substrate in a circulating electrolyte solution within the etching chamber;
generating a turbulent flow of the circulating electrolyte solution across a surface of the semiconductor substrate; and
illuminating the semiconductor substrate with UV light from the UV light source having a selected wavelength to irradiate the surface of the semiconductor substrate to etch the semiconductor substrate with a total thickness variation within tolerance.

Clause 15. The method of Clause 14, wherein generating the turbulent flow of the circulating electrolyte solution comprises directing the circulating electrolyte solution in the etching chamber using electrolyte nozzles connected to an electrolyte inlet.

Clause 16. The method of Clause 14, wherein generating the turbulent flow of the circulating electrolyte solution comprises applying a sonicator to the circulating electrolyte solution.

Clause 17. The method of Clause 14, wherein generating the turbulent flow of the circulating electrolyte solution comprises applying a sonicator to a photoelectrochemical flow cell forming the etching chamber.

Clause 18. The method of Clause 14, wherein generating the turbulent flow of the circulating electrolyte solution comprises stirring the circulating electrolyte solution in the etching chamber.

Clause 19. A method of photoelectrochemical etching a semiconductor substrate, the method comprising the steps of:
placing a semiconductor substrate in an etching chamber of a semiconductor photoelectrochemical etching apparatus having an optical path length set to collect high power light from an LED light source;
submerging the semiconductor substrate in a circulating electrolyte solution within the etching chamber;
generating a turbulent flow of the circulating electrolyte solution across a surface of the semiconductor substrate;
applying a bias voltage between the semiconductor substrate and a counter electrode in the circulating electrolyte solution; and
illuminating the semiconductor substrate with UV light from the LED light source having a selected wavelength below 300 nm to irradiate the surface of the semiconductor substrate with light uniformity >80% of the surface of the semiconductor substrate to etch the semiconductor substrate with a total thickness variation within tolerance.

Clause 20. The method of Clause 19, wherein generating the turbulent flow of the circulating electrolyte solution comprises directing the circulating electrolyte solution in the etching chamber using electrolyte nozzles connected to an electrolyte inlet. The description of the different illustrative embodiments has been presented for purposes of illustration and description, and is not intended to be exhaustive or limited to the embodiments in the form disclosed. Many modifications and variations will be apparent to those of ordinary skill in the art. Further, different illustrative embodiments may provide different features as compared to other illustrative embodiments. The embodiment or embodiments selected are chosen and described in order to best explain the principles of the embodiments, the practical application, and to enable others of ordinary skill in the art to understand the disclosure for various embodiments with various modifications as are suited to the particular use contemplated.

## Claims

1. A semiconductor photoelectrochemical etching apparatus (102; 202) comprising:
a photoelectrochemical flow cell (104; 212; 300; 400; 500);
a circulating electrolyte solution (110) propelled through the photoelectrochemical flow cell (104; 212; 300; 400; 500) by a circulating electrolyte pump (146);
a UV light source (128; 204) directed towards the photoelectrochemical flow cell (104; 212; 300; 400; 500), wherein an optical path length (126) between the UV light source (128; 204) and the photoelectrochemical flow cell (104; 212; 300; 400;, 500) is set to collect high power light from the UV light source (128; 204); and
a turbulence generator (148) configured to generate a turbulent flow (113) in the circulating electrolyte solution (110).

2. The semiconductor photoelectrochemical etching apparatus (102; 202) of claim 1, wherein the circulating electrolyte solution (110) comprises at least one of potassium hydroxide, sodium hydroxide, lithium hydroxide, hydrogen fluoride, or a buffer solution.

3. The semiconductor photoelectrochemical etching apparatus (102; 202) of claim 1 or 2, wherein the UV light source (128; 204) is a lamp configured to emit a narrow band or combination of narrow bands of light comprising wavelength (141) lower than 300 nm.

4. The semiconductor photoelectrochemical etching apparatus (102; 202) of any one of the preceding claims , wherein the optical path length (126) through the photoelectrochemical flow cell (104; 212; 300; 400; 500) is sufficient to collect more than 50 mW/cm2 from the UV light source (128).

5. The semiconductor photoelectrochemical etching apparatus (102; 202) of any one of the preceding claims , wherein the UV light source (128; 204) comprises a divergent LED light source (130; 204), and wherein the optical path length (126) is configured to collect high power light from the divergent LED light source (130; 204).

6. The semiconductor photoelectrochemical etching apparatus (102; 202) of any one of the preceding claims further comprising:
a ground glass diffuser configured to provide light uniformity (139) higher than 80% across a surface (162) of a semiconductor substrate (156; 220).

7. The semiconductor photoelectrochemical etching apparatus (102; 202) of any one of the preceding claims, wherein the UV light source (128; 204) is a LED light source (130; 204) or an excimer laser (138) or an excimer lamp.

8. The semiconductor photoelectrochemical etching apparatus (102; 202) of any one of claims 1 to 6, wherein the UV light source (128; 204) comprises at least one LED light source (130; 204) without lenses or a Mercury arc lamp (134) or a Mercury-Xenon arc lamp (136).

9. The semiconductor photoelectrochemical etching apparatus (102; 202) of any one of the preceding claims, wherein the photoelectrochemical flow cell (104; 212; 300; 400; 500) comprises nozzles (108; 304; 404; 504) configured to receive the circulating electrolyte solution (110) from the circulating electrolyte pump (146) and to generate a flow (112) pattern that results in a turbulent flow (113) across a surface (162) of a semiconductor substrate (156; 220) in the semiconductor photoelectrochemical etching apparatus (102;, 202).

10. The semiconductor photoelectrochemical etching apparatus (102; 202) of any one of the preceding claims wherein the turbulence generator (148) comprises a piezoelectric (152) positioned for vibration to induce turbulent flow (113) at a surface (162) of a semiconductor substrate (156, 220).

11. The semiconductor photoelectrochemical etching apparatus (102; 202) of any one of the preceding claims, further comprising:
at least one of a number of process monitoring ports (122) or a number of process monitoring windows (124).

12. A method (600) of photoelectrochemical etching a semiconductor substrate, said method (600) comprising the steps of:
placing a semiconductor substrate in an etching chamber of a semiconductor photoelectrical etching apparatus having an optical path length set to collect high power light from a UV light source(602);
submerging the semiconductor substrate in a circulating electrolyte solution within the etching chamber (604);
generating a turbulent flow of the circulating electrolyte solution across a surface of the semiconductor substrate (606); and
illuminating the semiconductor substrate with UV light from the UV light source having a selected wavelength to irradiate the surface of the semiconductor substrate to etch the semiconductor substrate with a total thickness variation within tolerance (608).

13. The method (600) of claim 12, wherein generating the turbulent flow of the circulating electrolyte solution (606) comprises directing the circulating electrolyte solution in the etching chamber using electrolyte nozzles connected to an electrolyte inlet (610).

14. The method (600; 700) of claim 12, wherein generating the turbulent flow of the circulating electrolyte solution (606) comprises either applying a sonicator to the circulating electrolyte solution (612) or applying a sonicator to a photoelectrochemical flow cell forming the etching chamber (614).

15. The method (600; 700) of claim 12, wherein generating the turbulent flow of the circulating electrolyte solution (606) comprises stirring the circulating electrolyte solution in the etching chamber (616).
